Europäisches Patentamt

European Patent Office

Office européen des brevets

(11) Veröffentlichungsnummer: **0 314 051**
**A2**

## (12) EUROPÄISCHE PATENTANMELDUNG

(21) Anmeldenummer: 88117710.9

(22) Anmeldetag: 25.10.88

(51) Int. Cl.4: **B05D 3/12**

(30) Priorität: 28.10.87 DE 3736391

(43) Veröffentlichungstag der Anmeldung:
03.05.89 Patentblatt 89/18

(84) Benannte Vertragsstaaten:
CH DE ES FR GB IT LI NL SE

(71) Anmelder: DU PONT DE NEMOURS
(DEUTSCHLAND) GMBH
Du Pont Strasse 1
D-6380 Bad Homburg(DE)

(72) Erfinder: Dudek, Dietmar, Dr.
Philipp-Reis-Strasse 6
D-6370 Oberursel(DE)
Erfinder: Stoll, Reiner, Dr.
Kaiser-Karl-Strasse 2
D-6453 Seligenstadt(DE)
Erfinder: Hooley, Robert W.
703 Farmhouse Court
Wilmington, Del. 19808(US)
Erfinder: Pfeiffer, Thomas, Dr.
Kampenweg 1
D-6057 Dietzenbach(DE)

(74) Vertreter: Seids, Heinrich, Dipl.-Phys.
Bierstadter Höhe 15 Postfach 5105
D-6200 Wiesbaden(DE)

(54) **Verfahren zum Beschichten von vorher klebrig gemachten Oberflächenbereichen.**

(57) Zur Beschichtung von vorher klebrig gemachten Oberflächenbereichen mit pulverförmigem Beschichtungsmaterial, dessen Teilchengröße zwischen 0,5 $\mu$m und 10 $\mu$m liegen kann, wird eine Vibration, vornehmlich im Frequenzbereich von 20 bis 5000 $H_z$, an dem Beschichtungsmaterial oder an dem zu beschichtenden Körper über die gewünschte Beschichtungszeit oder zumindest einen Teil davon ausgeübt. Die Schallstärke der Vibration sol zwischen Grenze $\Lambda_1$ und $\Lambda_2$ in einem Bereich liegen, in welchem das pulverförmige Beschichtungsmaterial unter der Wirkung der Vibration verdichtet, vornehmlich bis zu einer Maximaldichte $\rho$ max verdichtet wird.

_Fig. 1_

## Verfahren zum Beschichten von vorher klebrig gemachten Oberflächenbereichen

Die Erfindung betrifft ein Verfahren zum Beschichten von vorher klebrig gemachten Oberflächenbereichen, insbesondere von durch Bestrahlung klebrig gemachten Bereichen von Kunststoffoberflächen, an Werkstücken oder sonstigen Gegenständen, mit pulverförmigem Beschichtungsmaterial wie Farbstoffpulver, Metallpulver u.dgl., bei dem das pulverförmige Beschichtungsmaterial mit der die klebrigen Oberflächenteile enthaltenden, zu behandelnden Oberfläche in Berührung gebracht wird.

Für das Tonen von klebrigen insbesondere bildmäßig klebrigen Oberflächen, sind unterschiedliche Verfahren aus US-PS 3,060,024, US-PS 3,391,455, US-PS 3,506,483, US-PS 3,637,385, US-PS 3,649,268 und US-PS 4,019,821 bekannt. Grundsätzlich wird bei diesen bekannten Verfahren das Tonen unter Einsatz mechanischer Vorrichtungen zum Verteilen und Einarbeiten der Tonerpartikel in die klebrigen Flächenbereiche durchgeführt, beispielsweise mittels Bürsten, Wattebauschen usw.. Voraussetzung für die Durchführbarkeit dieser Verfahren ist ein ausgeprägter Härteunterschied zwischen den klebrigen·und den nichtklebrigen Oberflächenbereichen. Aufgrund der Härte der nichtklebrigen Oberflächenbereiche besteht dann keine Gefahr, daß durch die mechanischen Kräfte während des Tonens die Oberfläche in diesen nichtklebrigen Bereichen verletzt wird und unerwünschterweise Tonerpartikel eingearbeitet werden. Wenn die nichtklebrigen Oberflächenbereiche ausreichende Härte aufweisen, können Tonerpartikel, die nach dem Tonen auf der nichtklebrigen Fläche zurückbleiben und somit störend für das Pulverbild sind, unter Einsatz mechanischer Kräfte entfernt werden, beispielsweise abgewischt werden.
Diese genannten Verfahren versagen aber aufgrund der zum Einsatz kommenden mechanischen Energie, wenn äußerst feinteilige Toner (ca. 1 bis 2 μm mittlere Korngröße) aufgetragen werden sollen oder wenn die Härte im nichtklebrigen Oberflächenbereich gering ist oder wenn nichtebene bzw. gekrümmte oder gewölbte Oberflächen getont werden sollen oder insbesondere wenn sich die klebrigen und nichtklebrigen Oberflächenbereiche in der Härte nur wenig unterscheiden. Die Strukturgröße von Borsten bzw. Fasern der Bürsten oder Bausche beträgt mindestens einige Mikron (μm), so daß sogenannter "stain", ein Schleier aus feinsten Partikeln, mit diesen Mitteln nach dem Tonen nicht fortgewischt werden kann. Zudem sind diese Materialien so hart, daß die nichtklebrige aber relativ weiche Oberfläche leicht verletzt werden kann und sich die feinen Tonerpartikel in diesen Vertiefungen sammeln können. Darüberhinaus passen sich Bürsten und Bausche nur schlecht oder garnicht strukturierten oder nichtebenen Flächen an.

Andere bekannte Verfahren beruhen auf der Erzeugung und Ausnutzung einer freifließenden Tonerschicht, z.B. Eintauchen der zu tonenden Oberfläche in eine Wirbelschicht (R.W. Pfeifer und R.W. Woodruff, Research Disclosure 15882, Juni 1977) und führen zu Pulverbildern geringer Füllung. Freifließende Tonerflächen sind für das Tonen von in der Härte wenig, in der Klebrigkeit jedoch stark differenzierten Oberflächen eher brauchbar. Der Nachteil dieser Methoden liegt jedoch darin, daß aufgrund des stark aufgelockerten Toners Pulverbilder äußerst geringer Volumendichte und geringer Gleichmäßigkeit entstehen.

Schließlich ist aus EP O 214 335 A1 ein Verfahren zum Beschichten von Bildschirmen mit Phosphor bekannt, bei welchem der zu beschichtende Bildschirm um eine allseitig rechtwinklige Achse zu seiner zu beschichtenden, vorher klebrig gemachten Oberfläche unter Schrägstellung dieser achse rotiert wird, wobei vor dem Rotieren oder während des Rotierens der Phosphor als Feinteilchen auf diese Oberfläche gegeben wird. Um das Verteilen des Phosphors über die zu beschichtende Oberfläche zu erleichtern, kann der Bildschirm während des Rotierens zusätzlich vibriert werden. Auch in diesem Verfahren läßt sich nur sehr geringe Volumendichte und geringe Gleichmäßigkeit der Beschichtung erreichen, weil das Beschichtungsmaterial, d.h. der Phosphor während des Rotierens des Bildschirmes nur über dessen klebrig gemachte Oberfläche hinweg gleitet, wobei dieses Gleiten durch Vibration nur noch verbessert und die Neigung des Phosphors zum Haften an der klebrig gemachten Oberfläche vermindert wird.

Die mit Wirbelschicht-Beschichtung und Rotationsbeschichtung erzielbare nur geringe Volumendichte ist für viele Anwendungszwecke ungeeignet. Dies gilt insbesondere dann, wenn z.B. Metallpulverbilder durch Einbrennen in kontinuierliche Metallfilme überführt werden sollen.

Demgegenüber ist es Aufgabe der Erfindung, ein Verfahren zum Beschichten von klebrigen oder vorher klebrig gemachten Oberflächenbereichen zur Verfügung zu stellen, mit welchem bildmäßige Beschichtungen in den klebrigen Bereichen mit homogenem Pulverbild hoher Packungsdichte und hoher aufgenommener Tonermenge mit guter Reproduzierbarkeit aus feinteiligen Pulvern herzustellen sind, auch wenn sich die klebrigen Bereiche und die nichtklebrigen Bereiche der Oberfläche in der Härte nur wenig unterscheiden, wobei in dem nichtklebrigen Bereich keine oder nur durch elektrostatische Aufladung haftende Partikel zurückbleiben sollen und sämtliche Bestandteile des Toners in gleicher Weise in den klebrigen Bereichen aufgenommen werden sollen, also sich keine Veränderung des Toners in seiner Zusammensetzung und in seinen Eigenschaften auftreten soll.

Diese Aufgabe wird im erfindungsgemäßen Verfahren dadurch gelöst, daß das pulverförmige Beschichtungsmaterial in Berührung mit der zu behandelnden Oberfläche durch zumindest während eines Teils der Berührungszeit fortwährende Vibration über seine Schüttdichte hinaus verdichtet und nach Aufheben der Berührung des pulverförmigen Beschichtungsmaterials mit der zu behandelnden Oberfläche restliches, loses Beschichtungsmaterial von der behandelten Oberfläche entfernt wird.

Das Beschichten unter Anwendung von Vibration läßt sich mit jeglichem pulverförmigem Beschichtungsmaterial ausführen, insbesondere auch mit äußerst feinteiligem Beschichtungsmaterial, dessen mittlere Korngröße ca. 0,5 $\mu$m bis 10 $\mu$m beträgt. Das erfindungsgemäße Beschichtungsverfahren mittels Vibration zeichnet sich dadurch aus, daß auch bei geringen Härteunterschieden die Differenzierung zwischen klebrigen und nichtklebrigen Flächenteilen ausgezeichnet ist. Dabei ist es überraschend, daß auf Oberflächen geringer Härte im erfindungsgemäßen Verfahren mit Vibration gefahrlos gearbeitet werden kann und dabei die Schleierbildung deutlich reduziert wird. Das bildmäßige Beschichten kann im erfindungsgemäßen Verfahren an Flächen jeglicher Wölbung und jeglichen Oberflächenprofils ebensogut wie an ebenen Oberflächen ausgeführt werden.

Dabei tritt überraschenderweise eine gegenüber den bisherigen Verfahren erheblich vergrößerte Füllung der beschichteten Flächen, also eine beträchtlich erhöhte Beschichtungsdichte ein. Besonders überraschend ist es im erfindungsgemäßen Verfahren, daß durch die angewandte Vibration ein Selbstreinigungseffekt eintritt, der die Schleierbildung an der behandelten Oberfläche deutlich reduziert. Die im erfindungsgemäßen Verfahren durchgeführte Beschichtung zeichnet sich dabei durch gute Reproduzierbarkeit aus.

In einer besonders vorteilhaften Ausführungsform des erfindungsgemäßen Verfahrens wird die zu behandelnde Oberfläche nach oben gerichtet und durch Aufbringen einer Lage von pulverförmigem Beschichtungsmaterial mit diesem in Berührung gebracht, wobei die Vibration von der zu behandelnden Oberfläche her und bzw. oder gegen die zu behandelnde Oberfläche in die Lage von pulverförmigem Beschichtungsmaterial eingeleitet wird. Das Beschichtungsmaterial lagert sich somit unter Verdichtung auf die zu behandelnde Oberfläche. Dabei kann die Lage von pulverförmigem Beschichtungsmaterial auf die zu behandelnde Oberfläche gebracht werden, nachdem der diese Oberfläche tragende Gegenstand bereits vorher in Vibration versetzt worden ist. Es ist aber auch möglich, das pulverförmige Beschichtungsmaterial auf die zu behandelnde Oberfläche aufzubringen und danach in die das Beschichtungsmaterial verdichtende Vibration zu versetzen. Als weitere Möglichkeit zur Durchführung dieser Ausführungsform des erfindungsgemäßen Verfahrens kann man auch den Gegenstand während der Vibration mit seiner zu beschichtenden Oberfläche nach oben wenden und dabei die Lage aus pulverförmigem Beschichtungsmaterial unter Vibration des Gegenstandes auf dessen Oberfläche aufbauen.

Diese erste Ausführungsform des erfindungsgemäßen Verfahrens mit ihren diversen Abwandlungsmöglichkeiten bietet den besonderen Vorteil, daß das pulverförmige Beschichtungsmaterial als Lage auf der zu behandelnden Oberfläche lagert und dadurch mittels der Vibration besonders wirksam in die klebrigen Oberflächenteile eingearbeitet werden kann.

Eine andere Ausführungsform des erfindungsgemäßen Verfahrens sieht vor, daß die zu behandelnde Oberfläche auf das in Vibration gesetzte, verdichtete, pulverförmige Beschichtungsmaterial aufgelegt wird. In dieser Ausführungsform der Erfindung kann durch das Gewicht des die zu behandelnde Oberfläche tragenden Werkstücks oder Gegenstandes oder auch auf andere Weise ein Auflagedruck auf die sich unter der Vibration verdichtende Lage von pulverförmigem Beschichtungsmaterial ausgeübt werden. Die Größe dieses Auflagedruckes kann entsprechend dem Ausmaß der Klebrigkeit und der Härte der nichtklebrigen Flächenteile sowie entsprechend der Art des jeweiligen Beschichtungsmaterials vorher festgelegt werden.

In einer weiteren Ausführungsform des erfindungsgemäßen Verfahrens kann der Gegenstand mit seiner zu behandelnden Oberfläche in das in Vibration versetzte, verdichtete, pulverförmige Beschichtungsmaterial eingetaucht werden.

Bei allen Ausführungsformen des erfindungsgemäßen Verfahrens empfiehlt es sich, daß nach Beendigung des Beschichtens und Entfernen der Lage von losem pulverförmigem Beschichtungsmaterial von der Oberfläche des Gegenstandes noch restliches, nicht an die Oberfläche des Gegenstandes gebundenes, pulverförmiges Material mittels eines Strahles von gasförmigem Medium von der Oberfläche abgeblasen wird. Dieses Abblasen oder Abduschen der behandelten Oberfläche mittels gasförmigem Medium ergibt im erfindungsgemäßen Verfahren praktisch vollständige Entfernung von losem pulverförmigem Beschichtungsmaterial und läßt die Entstehung von Schleiern vermeiden.

Ergänzend kann im erfindungsgemäßen Verfahren die gebildete Schicht aus Beschichtungsmaterial nach dem Entfernen des restlichen losen Beschichtungsmaterials zusätzlich verdichtet und/oder fixiert werden.

Das erfindungsgemäße Verfahren läßt sich besonders vorteilhaft ausführen unter Einsatz von pulverförmigem Beschichtungsmaterial mit Teilchengröße zwischen etwa 0,5µm und 10µm. Für die Bildung elektrisch leitfähiger Flächenteile, insbesondere in gedruckten elektrischen Schaltungen können Kupferpulver oder Goldpulver mit mittlerer Teilchengröße zwischen 1µm und 5µm vorteilhaft eingesetzt werden.

Bei Bildung elektrisch leitfähiger Oberflächenbereiche, beispielsweise an elektrischen Leiterplatten, können im Rahmen der Erfindung die aus elektrisch leitfähigem Metallpulver, beispielsweise Kupferpulver, gebildeten, beschichteten Oberflächenbereiche nach dem Entfernen des restlichen losen Metallpulvers zur Erhöhung der elektrischen Leitfähigkeit zusätzlich verdichtet und/oder zusammengesintert werden.

In der Durchführung des erfindungsgemäßen Verfahrens können die Amplitude und Frequenz der Vibration am Gegenstand der Erzielung maximaler Verdichtung des pulverförmigen Beschichtungsmaterials abgestimmt werden. Durch die Möglichkeit dieser gegenseitigen Abstimmung ist das erfindungsgemäße Verfahren für pulverförmige Beschichtungsmaterialien jeglicher Art anwendbar, da durch die Variation dieser beiden Bestimmungsgrößen den jeweiligen Eigenschaften und der jeweiligen Beschaffenheit des anzuwendenden Beschichtungsmaterials optimal Rechnung getragen werden kann. Die Amplitude der Vibration kann dabei beispielsweise auf etwa die Größenordnung des Teilchendurchmessers des einzusetzenden pulverförmigen Beschichtungsmaterials, beispielsweise auf das Einfache bis Fünffache des Teilchendurchmessers, eingestellt werden.

Im allgemeinen wird man die Schwingungsrichtung der Vibration im wesentlichen in Normalrichtung zu dem zu beschichtenden Oberflächenteil einrichten. Die Vibration kann aber auch eine Komponente mit Schwingungsrichtung im wesentlichen in Normalrichtung und eine Komponente mit im wesentlichen tangential zu dem beschichtenden Oberflächenteil liegender Schwingungsrichtung aufweisen. Die Schwingungsrichtung der Vibration und bzw. oder die Lage des zu behandelnden Oberflächenteils kann jedoch auch während der Behandlungsdauer verändert werden, beispielsweise in Art ständig umlaufender Schwingungsrichtung.

Ausführungsbeispiele der Erfindung werden im folgenden anhand der Zeichnung näher erläutert. Es zeigen:

Fig. 1 eine Kurve bezüglich der Dichte einer Lage von Pulverförmigem Beschichtungsmaterial in Abhängigkeit von der an dieser Lage ausgeübten Schallstärke (ausgeübte Schalleistung pro Flächeneinheit);

Fig. 2 das Schaubild einer ersten Möglichkeit zur Durchführung der Beschichtung im erfindungsgemäßen Verfahren;

Fig. 3 das Schaubild einer zweiten Möglichkeit für die Beschichtung im Rahmen der Erfindung;

Fig. 4 eine dritte Möglichkeit für die Durchführung der Beschichtung im Rahmen des erfindungsgemäßen Verfahrens in drei aufeinanderfolgenden Stadien;

Fig. 5 das Schaubild einer vierten Möglichkeit zur Beschichtung im Rahmen der Erfindung;

Fig. 6 das Schaubild einer fünften Möglichkeit für die Durchführung der Beschichtung im Rahmen des erfindungsgemäßen Verfahrens;

Fig. 7 eine sechste Möglichkeit für die Durchführung der Beschichtung im Rahmen des erfindungsgemäßen Verfahrens
und

Fig. 8 das Schaubild für eine Möglichkeit zum Entfernen von überschüssigem Beschichtungsmaterial nach dem Beschichten.

Das neue Beschichtungsverfahren macht von der Tatsache Gebrauch, daß eine Lage aus pulverförmigem Material unter der Einwirkung von Vibration ausgehend von seiner Schüttdichte $\rho$ O mit zunehmender Schallstärke $\Lambda$ zunächst verdichtet wird bis zu einer maximalen Dichte $\rho$ max. Bei weiterer Steigerung der Schallstärke $\Lambda$ nimmt die Dichte in der Lage sehr schnell ab bis zur Auflösung der Lage in eine Wirbelschicht.

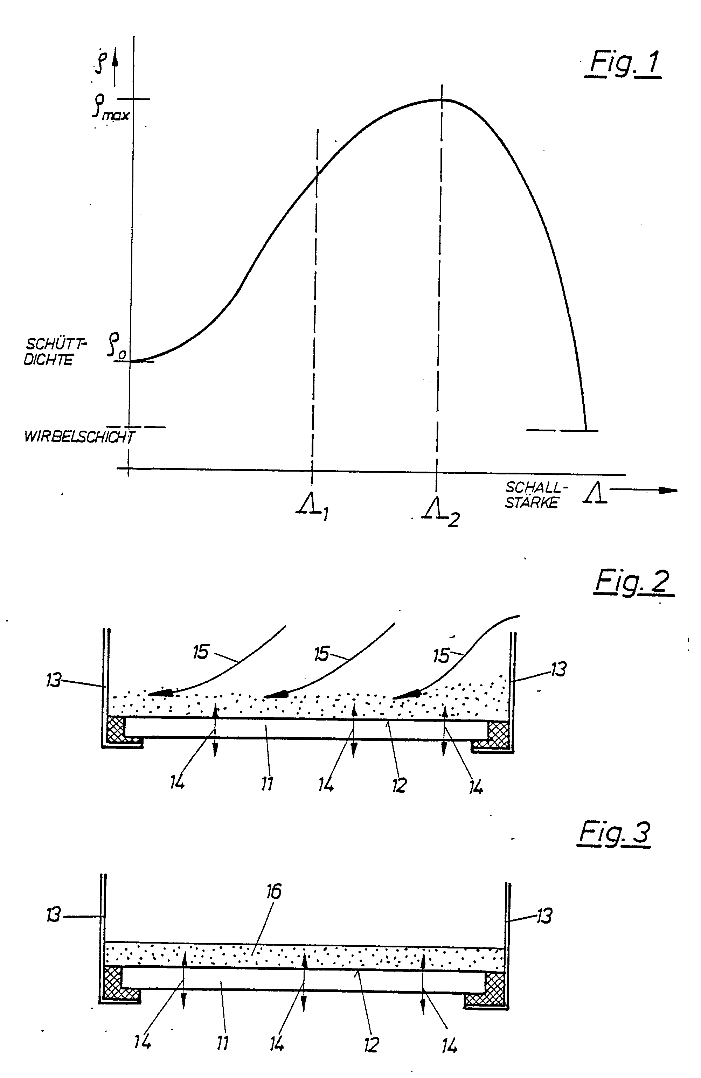

Ausgehend von dieser Erkenntnis soll im neuen Verfahren die bildmäßige Beschichtung einer in Bereichen klebrig gemachten Oberflächen geringer Härtedifferenz unter Zuhilfenahme von Vibration geschehen, wobei die Schalldichte $\Lambda$ dieser Vibration in einem Schalldichtebereich A einzurichten ist, der zwischen einer Schalldichte $\Lambda_1$ und einer Schalldichte $\Lambda_2$ leigt. Bei der schalldichte $\Lambda_1$ soll schon eine erhebliche Verdichtung des pulverförmigen Beschichtungsmaterials im Vergleich zu der Ausgangs-Schüttdichte $\rho O$ erreicht sein, während die obere Grenze $\Lambda_2$ der einzusetzenden Schalldichte etwa diejenige Schalldichte sein soll, bei der maximale Dichte $\rho$ max erreicht wird. Es wäre denkbar, daß die Schalldichte $\Lambda_2$ auch jenseits des Maximums der Dichte eingerichtet werden könnte. Jedoch ist es im Hinblick auf den aus Figur 1 ersichtlichen steilen Abfall der Dichtekurve jenseits der maximalen Dichte $\rho$ max empfehlenswert, die der maximalen Dichte $\rho$ max entsprechenden Schalldichtewert $\Lambda_2$ möglichst nicht zu überschrei-

ten.

Für die Beschichtung kommen pulverförmige Beschichtungsmaterialien unterschiedlicher Art in Betracht, beispielsweise Farbpigmentpulver, Kohlenstoffpulver, Metallpulver, insbesondere Kupferpulver usw.. Die Teilchengröße dieser Pulver soll zwischen etwa 0,5 µm und 10 µm liegen. Dabei empfiehlt es sich, eine statistische Teilchengrößen-Verteilung (Gauß'sche Glockenkurve) vorzusehen, bei der der maximale Anteil in dem zu verwendenden pulverförmigen Beschichtungsmaterial etwa bei mittlerer Teilchengröße des angegebenen Bereiches liegt. Bei einer solchen Teilchengrößen-Verteilung in dem pulverförmigen Beschichtungsmaterial läßt sich maximale Dichte in der Beschichtung erreichen.

Im Beispiel der Figur 2 wird ein an seiner Oberfläche 12 zu beschichtender Körper 11 schwingbar in einem Rahmen 13 eingesetzt und vibriert, wie dies durch die Doppelpfeile 14 angedeutet ist. Die Vibration kann bevorzugt im Frequenzbereich von 20 bis 5000 Hz liegen. Die Schwingungsrichtung soll - wie die Doppelpfeile 14 andeuten - möglichst in Normalrichtung zur Oberfläche 12 des Körpers 11 liegen. Während der Körper 11 im Sinne der Doppelpfeile 14 vibriert, wird auf die Oberfläche 12 innerhalb des Rahmens 13 pulverförmiges Beschichtungsmaterial im Sinne der Pfeile 15 aufgegeben. Der damit einsetzende Beschichtungsvorgang wird über eine vorher festgelegte Beschichtungszeit, beispielsweise zwischen etwa 0,5 Minuten und 10 Minuten unter fortgesetzter Vibration des Körpers 11 ausgeführt. Nach Ablauf der Beschichtungszeit wird die Vibration abgeschaltet. Das in den Rahmen 13 eingegebene Beschichtungsmaterial wird entfernt, beispielsweise abgesaugt. Der beschichtete Körper 11 wird aus dem Rahmen 13 entnommen und in einer weiter unten erläuterten Weise weiterbehandelt.

Im Beispiel der Figur 3 ist wiederum ein an seiner Oberfläche 12 zu beschichtender Körper 11 in einen Rahmen 13 eingesetzt, derart, daß die zu beschichtende Oberfläche nach oben gerichtet ist. Auf dieser zu beschichtenden Oberfläche 12 ist eine Lage 16 aus Beschichtungsmaterial innerhalb des Rahmens 13 gebildet. Nachdem diese Lage 16 auf den Körper 11 aufgebracht ist, wird dieser im Sinne der Doppelpfeile 14 über die vorher festgelegte Beschichtungsdauer vibriert.

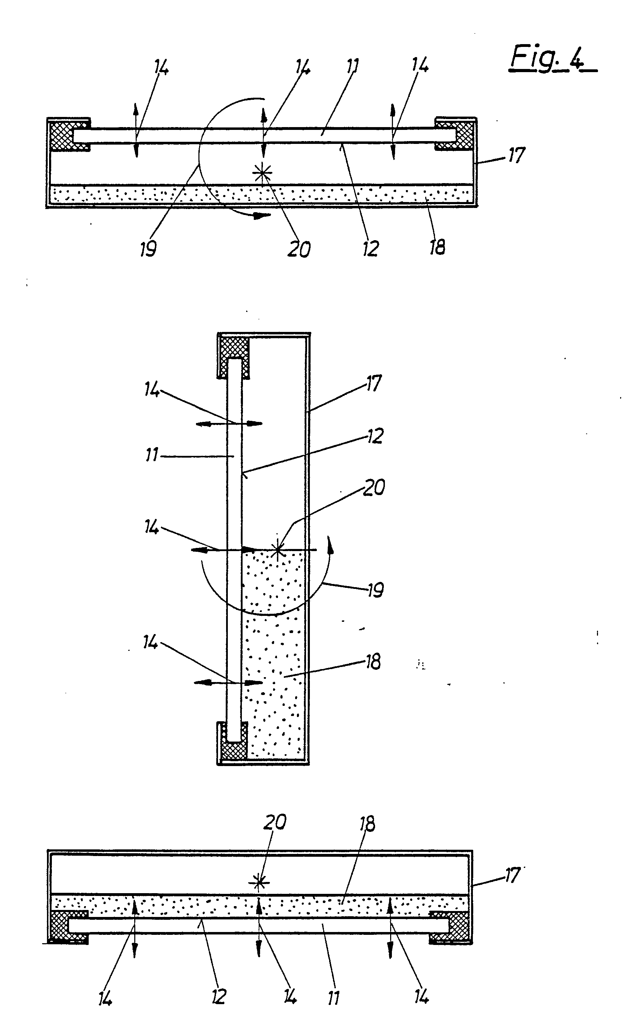

Bei der in Figur 4 in drei aufeinanderfolgenden Stadien angedeuteten Verfahrensweise ist anstelle des in Figur 2 und 3 angedeuteten Rahmens ein flacher, beispielsweise schalenförmiger Behälter 17 vorgesehen, auf dessen Boden das zur Beschichtung zu benutzende Material bei 18 eingefüllt ist. Der zu behandelnde Körper 11 wird in den Rand der zunächst nach oben gerichteten Öffnung des Behälters derart eingesetzt, daß die zu beschichtende Oberfläche 12 nach unten liegt und den auf dem Behälterboden liegenden Beschichtungsmaterial 18 zugewandt ist. Nach dem Einsetzen in den Öffnungsrand des Behälters 17 wird der Körper 11 im Sinne der Doppelpfeile 14 in Vibration versetzt, beispielsweise mit einer Frequenz von 20 bis 5000 Hz. Der Behälter 17 wird dann mit den in seinen Öffnungsrand eingesetzten vibrierenden Körper 11 im Sinne des Pfeiles 19 um die Achse 20 geschwenkt, wobei die im mittleren Teil der Figur 4 gezeigte Zwischenstellung durchlaufen wird, bis die im unteren Teil der Figur 4 gezeigte umgekehrte Stellung des Gehäuses 17 erreicht ist, in der das Beschichtungsmaterial 18 auf der jetzt nach oben gerichteten Oberfläche 12 des Körpers 11 verteilt ist. Die durch die Doppelpfeile 14 angedeutete Vibration wird in dieser Stellung des Gehäuses 17 über die gewünschte Beschichtungsdauer aufrecht erhalten.

Anstelle des Einschaltens der Vibration bereits nach Einsetzen des Körpers 11 in den Öffnungsrand des Behälters 17 kann auch die Vibration erst eingeschaltet werden, wenn das Gehäuse 17 mit eingesetztem Körper 11 die im unteren Teil der Figur 4 gezeigte Stellung eingenommen hat.

Nach Ablauf der gewünschten Beschichtungszeit wird der Behälter 17 mit dem eingesetzten Körper 11 in die im oberen Teil der Figur 4 gezeigte Stellung zurückgeschwenkt, so daß das Beschichtungsmaterial 18 von der Oberfläche 12 abfällt und sich wiederum auf den Boden des Behälters 17 legt. Das Zurückschwenken des Behälters 17 mit dem eingesetzten Körper 11 kann unter Aufrechterhaltung der Vibration im Sinne der Doppelpfeile 14 erfolgen. Dies bietet den Vorteil, daß die mit der Vibration hervorgerufene Verdichtungswirkung am Beschichtungsmaterial 18 bewirkt, daß das in einem verdichteten Zustand gehaltene Beschichtungsmaterial 18 auch solche Teilchen mitnimmt, die normalerweise an den nichtklebrigen Bereichen der Oberfläche 12 aus physikalsichen Gründen haften würden.

Der Verfahrensgang gemäß dem Schema der Figur 4 könnte auch in solcher Weise geführt werden, daß unter fortgesetzter Vibration die Schwenkbewegung des Gehäuses 17 mit in seinen Öffnungsrand eingesetztem Körper 11 um die Achse 20 im Sinne des Pfeiles 19 einfach oder mehrfach wiederholt wird, um auf diese Weise einen mehrstufigen Beschichtungsvorgang hervorzurufen. Es wäre auch denkbar, überhaupt die Schwenkbewegung des Gehäuses 17 mit in seinen Öffnungsrand eingesetzten Körper 11 im Sinne des Pfeiles 19 um die Achse 20 kontinuierlich unter fortgesetzter Vibration des Körpers 11 auszuführen.

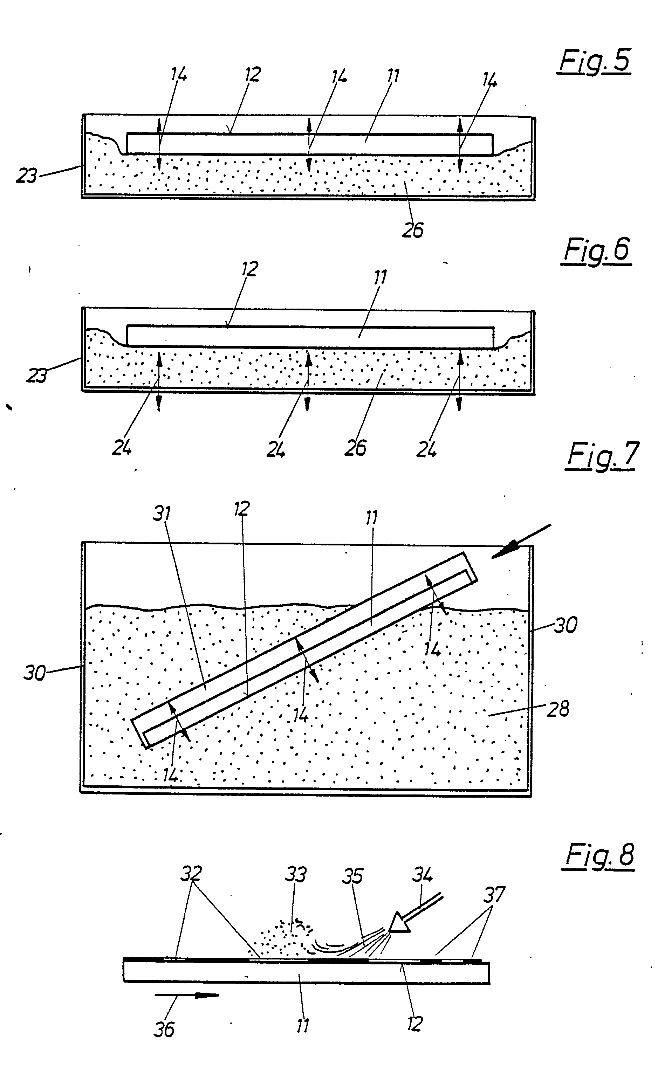

Eine andere Ausführungsform des Beschichtungsverfahrens ergibt sich anhand der Figuren 5 und 6. In diesem Beispiel ist ein oben offener, schalenartiger Behälter 23 vorgesehen, in dessen Inneren eine Lage 26 aus Beschichtungsmaterial gebildet ist. Auf diese Lage 26 ist der zu behandelnde Körper 11 mit seiner zu beschichtenden Oberfläche 12 aufgelegt, wobei wiederum der Körper 11 über die Dauer der gewünschten Beschichtungszeit vibriert wird, wie dies durch die Doppelpfeile 14 angedeutet ist. Die Schwingungsrichtung der Vibration liegt auch in diesem Beispiel im wesentlichen normal (allseitig rechtwinklig) zur Oberfläche 12 bzw. einer Tangentialebene zur Oberfläche 12. Nach Ablauf der Beschichtungszeit wird der Körper 11 von der Lage 26 abgehoben und in einer unten erläuterten Weise weiterbehandelt.

Eine Abwandlung des Verfahrensganges gemäß Figure 5 ergibt sich nach dem Schema der Figur 6 dahingehend, daß nicht der Körper 11 sondern der Behälter 23 mit der in ihm enthaltenen Lage 26 von Beschichtungsmaterial vibriert wird, wie dies in Figur 6 durch die Doppelpfeile 24 angedeutet ist. Dabei wird die Vibration vom Behälter 23 auf das Beschichtungsmaterial der Lage 26 und von dort auch auf den zu behandelnden Körper 11 übertragen. Es kommt auch in diesem Fall zu einer intensiven Einlagerung der Teilchen des Beschichtungsmaterials in die klebrig gemachten Bereiche der Oberfläche 12.

Schließlich ist in Figur 7 eine Möglichkeit angedeutet, wonach das Beschichtungsmaterial 28 in einem trogartigen Behälter 30 untergebracht ist und zunächst nur die in Figur 1 gezeigte normale Schüttdichte $\rho O$ aufweist. In dieses Beschichtungsmaterial 28 wird der unter Vibration gesetzt Körper 11 mit seiner freiliegenden zu beschichtenden Oberfläche 12 eingetaucht. In Figur 7 ist bei 31 eine die Vibration auf den Körper 11 übertragende Einrichtung angedeutet, wobei wiederum durch die Doppelpfeile 14 zum Ausdruck kommt, daß die Schwingungsrichtung der Vibration etwa normal (allseitig rechtwinklig) zur Oberfläche 12 bzw. einer Tangentialebene zur Oberfläche 12 liegen soll. Der in das Beschichtungsmaterial 28 eingetauchte Körper 11 verhält sich bezüglich der Beschichtung der klebrigen Bereiche der Oberfläche 12 praktisch gleich wie der Körper 11 im Beispiel der Figur 5.

Es wäre denkbar, auch beim Eintauchen des Körpers 11 in das Beschichtungsmaterial die Vibration vom Behälter 30 über das Beschichtungsmaterial 28 zum Körper 11 zu führen. Dies erscheint aber weniger zweckmäßig, weil die mit der Vibration erfolgende Verdichtung des Beschichtungsmaterials 28 erwarten läßt, daß ein Eintauchen des Körpers 11 in das Beschichtungsmaterial 28 wesentlich erschwert würde. Nach dem eigentlichen Beschichtungsvorgang, der nach einer der Möglichkeiten gemäß den Figuren 2 bis 7 ausgeführt werden kann, ist loses Beschichtungsmaterial 32 von der beschichteten Oberfläche 12 des Körpers 11 zu entfernen. Dies kann in einfacher Weise durch Blasen erfolgen. In Figur 8 ist hierzu eine Luftdusche 34 angedeutet, mit der ein auf die Oberfläche 12 gerichteter Luftfächer 35 erzeugt wird, während der Körper 11 im Sinne des Pfeiles 36 unter der Luftdusche 34 hinwegbewegt wird. Das nach dem eigentlichen Beschichtungsvorgang auf der Oberfläche 12, vornehmlich deren nichtklebrigen Bereichen, aber auch auf den Beschichtungen selbst verbleibenden, sehr feinen losen Teilchen 32 von Beschichtungsmaterial werden in Form einer Wolke 33 weggeblasen. Es verbleibt eine scharf begrenzte Beschichtung 37 der vorher klebrigen Bereiche der Oberfläche 12. Diese Beschichtung 37 zeichnet sich durch hohe Dichte und feste Verbindung mit der Oberfläche 12 aus, wobei das klebrige Material an der Oberfläche 12 innerhalb der Beschichtung 37 in das Beschichtungsmaterial eingearbeitet ist. Für viele Zwecke reicht bereits diese Verbindung der Beschichtung 37 mit der Oberfläche 12 aus. Eine weitere Festigung der Beschichtung 37 läßt sich dadurch erreichen, daß durch Temperatureinwirkung oder sonstige physikalische Einwirkung das klebrige Material innerhalb der Beschichtung 37 nachträglich ausgehärtet wird. Sofern die Beschichtung 37 aus Metallpulver gebildet ist und elektrisch leitfähig gemacht werden soll, kann die Beschichtung 37 zusammengesintert werden, wobei ggf. das bis dahin eingearbeitete klebrige Material aus der Beschichtung 37 ausgetrieben und die gesinterte, nunmehr praktisch vollständig metallische Beschichtung 37 während des Sinterns direkte Bindung mit dem Material des Körpers 11 oder einer auf ihm gebildeten Oberflächenschicht eingeht.

## Beispiel 1

Eine Lösung von

3,25 g Dimethylester der 2,6-Dimethyl-4-(2′-nitrophenyl)-1,4-dihydropyridin-3,5-dicarbonsäure und

3,25g Diethylester der 2,6-Dimethyl-4-(2′-nitrophenyl)-1,4-dihydropyridin-3,5-dicarbonsäure

in 100 ml Methylethylketon wurde durch Schleuderbeschichtung auf die Innenseite eines Glasträgers für einen 14-Zoll-Farbfernsehbildschirm aufgetragen. Die getrocknete Schicht hatte eine Dicke von 1,2$\mu$m. Der Schirm wurde auf einen dafür bestimmten Belichtungstisch durch eine Schattenmaske mit schlitzförmigen Öffnungen 40 s lang mit einer 1000 W Quecksilberdampflampe aus 20 cm Abstand belichtet.
Danach wurde die Schicht mit einem grün leuchtenden Phosphor getönt, dessen mittlerer Teilchen-

durchmesser 4μm betrug, wodurch ein Muster grünemittierender Striche entstand. Hierzu wurde der
Schirm mit der Schicht nach unten gerichtet auf
einem passenden Behälter befestigt, dessen Boden
mit einer 2,5 cm dicken Schicht des Phosphors
bedeckt war und an dem ein druckluftbetriebener
Unwuchtvibrator befestigt war. (Ein Vibrator dieser
Bauart erzeugt eine Schwingung sowohl senkrecht
als auch parallel zu der zu tonenden Oberfläche.)
Nach Beginn der Vibration wurde die Einheit aus
Behälter und Schirm langsam um 270° hin und her
gedreht, so daß das Phosphorpulver 35 s lang in
Berührung mit der Schicht war. Die Hauptfrequenz
der Vibration war 200 Hz. Die Komponente der
Amplitude normal zur Schirmoberfläche wurde aus
Messungen mit einem am Schirm befestigten Beschleunigungssensor berechnet und betrug 10μm.
Der Schirm wurde dann von dem Behälter abgenommen und der Überschuß an Phosphor mit Luft
abgeblasen. Man erhielt ein sehr gleichmäßiges
Phosphormuster. Belichtung und Tonen wurden in
entsprechender Weise wiederholt, um Muster aus
blau und rot leuchtenden Phosphoren hinzuzufügen.

## Beispiel 2

Ein Behälter mit quadratischem Grundriß, der
teilweise mit 2μm Goldpulver gefüllt war, wurde mit
einem quadratischen keramischen Träger für gedruckte Schaltungen verschlossen. Auf der inneren
Seite dieses Trägers befand sich eine 1,5μm dicke
Schicht aus dem lichtempfindlichen Material des
Beispiels 1, welche mit UV-Strahlung mit dem Muster eines Schaltungsbildes belichtet worden war.
Auf der Rückseite des Trägers wurde ein Piezotranslator (Typ p-245.20, Physikinstrumente GmbH,
D-7517 Waldbronn) befestigt, der mittels einer
Steuereinheit (PI 272 des gleichen Lieferanten) zu
einer Schwingung von 100 Hz angeregt wurde. Die
Amplitude der Schwingung betrug 10μm. Auf diese
Weise wurde der keramische Träger in Vibration
versetzt. Behälter und Träger wurden nun um eine
waagerechte Achse mehrfach um 180° hin und her
gedreht. Das so getonte Schaltungsbild hatte eine
hervorragende Flächendichte (10 mg Gold/cm$^2$)
und Auflösung (25μm).

## Bezugszeichenliste

11 Körper
12 Oberfläche
13 Rahmen
14 Doppelpfeil (Vibration)
15 Pfeil (Beschichtungsvorgang)
16 Beschichtungsmaterial

17 Behälter/Gehäuse
18 Beschichtungsmaterial
19 Pfeil
20 Achse
23 schalenartiger Behälter
24 Doppelpfeil (Vibration)
26 Lage/Beschichtungsmaterial
28 Beschichtungsmaterial
30 trogartiger Behälter
32 loses Beschichtungsmaterial
33 Wolke
34 Luftdusche
35 Luftfächer
36 Pfeil (Bewegungsrichtung)
37 Beschichtung

## Ansprüche

1) Verfahren zum Beschichten von vorher klebrig gemachten Oberflächenbereichen, insbesondere von durch Bestrahlung klebrig gemachten Bereichen von Kunststoffoberflächen, an Werkstücken
oder sonstigem Gegenständen, mit pulverförmigem
Beschichtungsmaterial, wie Farbstoffpulver, Metallpulver, bei dem das pulverförmige Beschichtungsmaterial mit der die klebrigen Oberflächenteile enthaltenden, zu behandelnden Oberfläche in Berührung gebracht wird,
dadurch gekennzeichnet, daß
das pulverförmige Beschichtungsmaterial in Berührung mit der zu behandelnden Oberfläche durch
zumindest während eines Teils der Berührungszeit
fortwährende Vibration über seine Schüttdichte hinaus verdichtet und nach Aufheben der Berührung
des Pulverförmigen Beschichtungsmaterials mit der
zu behandelnden Oberfläche restliches loses Beschichtungsmaterial von der behandelten Oberfläche entfernt wird.

2) Verfahren nach Anspruch 1, dadurch gekennzeichnet, daß die zu behandelnde Oberfläche
nach oben gerichtet und durch Aufbringen einer
Lage von pulverförmigem Beschichtungsmaterial
mit diesen in Berührung gebracht wird, wobei die
Vibration von der zu behandelnden Oberfläche her
und bzw. oder gegen die zu behandelnde Oberfläche in die Lage von pulverförmigem Beschichtungsmaterial eingeleitet wird.

3) Verfahren nach Anspruch 2, dadurch gekennzeichnet, daß die Lage von pulverförmigem
Beschichtungsmaterial auf die zu behandelnde
Oberfläche gebracht wird, nachdem der die Oberfläche tragende Gegenstand bereits vorher in Vibration versetzt worden ist.

4) Verfahren nach Anspruch 2, dadurch gekennzeichnet, daß das pulverförmige Beschichtungsmaterial auf die zu behandelnde Oberfläche aufgebracht und danach in die das Beschichtungsmaterial verdichtende Vibration versetzt wird.

5) Verfahren nach Anspruch 1, dadurch gekennzeichnet, daß die zu behandelnde Oberfläche auf das in Vibration versetzte, verdichtete, pulverförmige Beschichtungsamterial aufgelegt wird.

6) Verfahren nach Anspruch 1, dadurch gekennzeichnet, daß der Gegenstand mit seiner zu behandelnden Oberfläche in das in Vibration versetzte, verdichtete, pulverförmige Beschichtungsmaterial eingetaucht wird.

7) Verfahren nach einem der Ansprüche 1 bis 6, dadurch gekennzeichnet, daß nach Beendigung des Beschichtens und Entfernen der Lage von losem, pulverförmigem Beschichtungsmaterial von der Oberfläche des Gegens noch restliches, nicht an die Oberfläche des Gegenstandes gebundenes, pulverförmiges Material mittels eines Strahles von gasförmigem Medium von der Oberfläche abgeblasen wird.

8) Verfahren nach einem der Ansprüche 1 bis 7, dadurch gekennzeichnet, daß die gebildete Schicht aus Beschichtungsmaterial nach dem Entfernen des restlichen losen Beschichtungsmaterials zusätzlich verdichtet wird.

9) Verfahren nach einem der Ansprüche 1 bis 8, dadurch gekennzeichnet, daß die Schicht aus Beschichtungsmaterial nach dem Entfernen des restlichen losen Beschichtungsmaterials zusätzlich fixiert wird.

10) Verfahren nach einem der Ansprüche 1 bis 9, dadurch gekennzeichnet, daß pulverförmiges Beschichtungsmaterial mit Teilchengröße zwischen 0,5µm und 10µm eingesetzt wird.

11) Verfahren nach einem der Ansprüche 1 bis 10, gekennzeichnet durch den Einsatz von Kupferpulver oder Goldpulver mit mittlerer Teilchengröße zwischen 2µm und 5 , als Beschichtungspulver für die Herstellung elektrisch leitfähiger Flächenbereichen, insbesondere in gedruckten elektrischen Schaltungen.

12) Verfahren nach einem der Ansprüche 1 bis 12, dadurch gekennzeichnet, daß bei Bildung elektrisch leitfähiger Oberflächenbereiche, die aus elektrisch leitfähigem Metallpulver, beispielsweise Kupferpulver, gebildeten, beschichteten Oberflächenbereiche nach dem Entfernen des restlichen losen Metallpulvers zur Erhöhung der elektrischen Leitfähigkeit zusätzlich verdichtet und/oder zusammengesintert werden.

13) Verfahren nach einem der Ansprüche 1 bis 12, dadurch gekennzeichnet, daß die Amplitude der Vibration auf die Größenordnung des Teilchendurchmessers des eingesetzten pulverförmigen Beschichtungsmaterials eingestellt wird.

14) Verfahren nach Anspruch 13, dadurch gekennzeichnet, daß die Amplitude der Vibration auf das 1- bis 5-fache des Teilchendurchmessers des eingesetzten pulverförmigen Beschichtungsmaterials eingestellt wird.

15) Verfahren nach einem der Ansprüche 1 bis 14, dadurch gekennzeichnet, daß die Schwingungsrichtung der Vibration im wesentlichen in Normalrichtung zu dem zu beschichtenden Oberflächenteil eingerichtet wird.

16) Verfahren nach einem der Ansprüche 1 bis 14, dadurch gekennzeichnet, daß eine Vibration mit einer Komponente, deren Schwingungsrichtung im wesentlichen in Normalrichtung zu dem zu beschichtenden Oberflächenteil liegt und einer Komponente eingerichtet wird, deren Schwingungsrichtung im wesentlichen tangential zu dem zu beschichtenden Oberflächenteil liegt.

17) Verfahren nach einem der Ansprüche 1 bis 14, dadurch gekennzeichnet, daß die Schwingungsrichtung der Vibration und/oder die Lage des zu behandelnden Oberflächenteils während der Behandlungsdauer verändert werden.

18) Verfahren nach Anspruch 17, dadurch gekennzeichnet, daß eine Vibration mit ständig umlaufender Schwingungsrichtung eingerichtet wird.

_Fig. 1_

_Fig. 2_

_Fig. 3_

_Fig._4_

_Fig.5_

_Fig.6_

_Fig.7_

_Fig.8_